# EUROPEAN PATENT APPLICATION

(11) **EP 4 597 660 A2**
(43) Date of publication of application: **06.08.2025**
(21) Application number: 25151638.1
(22) Date of filing: 14.01.2025
(51) Int. Cl.: H01M 10/04, B65G 1/04, G01R 31/385, H01M 10/42

(54) **A MANUFACTURING ARRANGEMENT TO RECHARGEABLE BATTERY CELL FORMATION AND AGING PROCESSES**

(30) Priority: 01.02.2024 FI 20245097
(71) Applicant: CIMCORP OY, 28400 Ulvila (FI)
(72) Inventor: HAKALA, Veli-Matti, Ulvila (FI); HONKANEN, Jarno, Ulvila (FI); YLIPAINO, Jari-Pekka, Ulvila (FI); ANTTONEN, Jyrki, Ulvila (FI)
(74) Representative: Berggren Oy

(57) **Abstract**

A manufacturing arrangement to rechargeable battery cell formation and aging processes according to the invention has rooms (2, 3, 4) for the formation process and for the aging process. The arrangement has also testing devices (8A, 8B, 8C, 8D, 8E, 8F) The rooms and test devices being situated on a floor (9). The arrangement further comprises a mezzanine floor (10) above the floor. On the mezzanine floor there is at least one linear robot system (11). The arrangement further comprises conveyors (14) on the mezzanine floor (10). Each of said rooms (2, 3, 4) has interfaces (15) being in a functional connection to at least one of the conveyors (14) in order to transport the rechargeable battery cells. The mezzanine floor has also openings (16). On the floor (9), the arrangement further comprises elevator conveyors (17) being in functional connection with the opening (16) in order to transfer the rechargeable battery cells from the mezzanine floor to the floor.

## Description

### Field of technology

The invention relates to a manufacturing arrangement to rechargeable battery cells, for example lithium-ion cells. Especially the invention relates to a manufacturing arrangement to rechargeable battery cell formation and aging processes.

### Prior art

The production of the rechargeable battery cell comprises three main stages, namely electrode manufacturing, cell assembly, and cell finishing. The usual types of the cells are prismatic, cylindrical, and pouch. Although the cell design can be different, the cell manufacturing processes are more or less similar. The rechargeable battery cells can, for example, be lithium-ion battery cells, sodium-ion battery cells, nickel manganese cobalt battery cells, nickel metal hydride battery cells, or lithium sulphur battery cells. Below an example of the production of the rechargeable battery cells relating especially to the lithium-ion battery cells is described, but similar manufacturing processes are also used with the other rechargeable battery cells.

First electrodes of the lithium-ion battery cells are manufactured. Li-ion (lithium-ion) cells comprise four main components - two electrodes: an anode, which holds the lithium ions when charged, and a cathode, which holds the lithium ions when discharged. Typically, the anode is made of graphite. The cathode can be an alloy of multiple metals, like nickel, cobalt, lithium, or other metal.

The electrode materials are mixed with a conductive binder to form a uniform slurry with the solvent. The anodes and cathodes are usually processed in different rooms in order to avoid contamination. The slurry is then coated on both sides of the electrode structure, like Al foil for cathode and Cu foil for the anode.

Then the coated foil is dried in an oven to evaporate the solvent. The solvent used in the cathode coating is typically highly flammable, and it is recovered or used for thermal production. Regarding the water-based anode coating, the vapor is exhausted to the ambient environment.

After the drying and solvent recovery, the coated foils are compressed (called calendaring) by a rotating pair of rollers. The compression helps to adjust the physical properties of the electrodes, like bonding, conductivity, density, and porosity.

After the calendaring, the electrodes are cleaned and slitted into narrow strips and recoiled. The coils are sent to a vacuum oven to remove the residual moisture and solvent.

After the processes described above the electrodes have been prepared for a cell assembly. The electrodes are moved to a sub-assembly process where a separator is layered between the anode and the cathode in order to form the internal structure of the cell, i.e. the structures to said prismatic, cylindrical, and pouch cells.

Next, the assembled cell structure is connected to the terminals (connections of the cell). The sub-assembly is then inserted into a cell housing, like a pouch or a cylindrical or prismatic metal case. The assembly is then sealed in a laser welding or heating process leaving an opening for injecting the electrolyte.

The housed cell is filled with the electrolyte. The filling process is carried out in a dry room since moisture can cause the electrolyte to decompose creating toxic gases. The finished cell is labeled with a serial number on the case.

The cell is now ready for cell finishing process. It comprises a formation and aging processes. The formation process determines the first charging and discharging processes of the battery cell. The cells are placed in racks and contacted by contact pins. The cells are charged and discharged according to precisely defined current and voltage curves.

During this process, lithium ions are embedded in the crystal structure of the graphite on the anode side, which forms a protective layer called Solid Electrolyte Interface (SEI) between the electrolyte and the electrode. The protective film creates the low self-discharge of Li-ion cell and also affects the performance and life of the cell.

In case of larger pouch cells, first charging causes strong evolution of gas. The gas can be pressed out of the cell into a dead space called a gas bag. This is called degassing. The cell is sealed under vacuum, and the gas in the bag is separated. The gas bag is disposed of hazardous waste.

Next, the cells are aged. The aging is done for quality purposes. During aging, cell characteristics and cell performance are monitored by regularly measuring the open-circuit voltage (OCV) of the cell over a period of up to three weeks, for example. So, the aging processes comprise also monitoring processes as well.

A distinction is made between high temperature (HT) and normal temperature (NT) aging. The cells are usually transferred first to the HT aging and after that to the NT aging. The cells are processed in aging shelves, cabinets, or rooms. Typically, these spaces are called as rooms.

If no significant change is monitored (results of intermediate tests) in the cell properties over the entire aging period, the cell is ready for a final test. After the aging process, the cells are tested in an end-of-line (EOL) test device. The cells are transferred to the testing device where they are discharged to the shipping state of charge utilizing capacity measurements. In addition, pulse tests, internal resistance measurements, optical inspections, OCV tests, and leakage tests can be made. Once the tests have been completed successfully, the cells can then be assembled in battery packs.

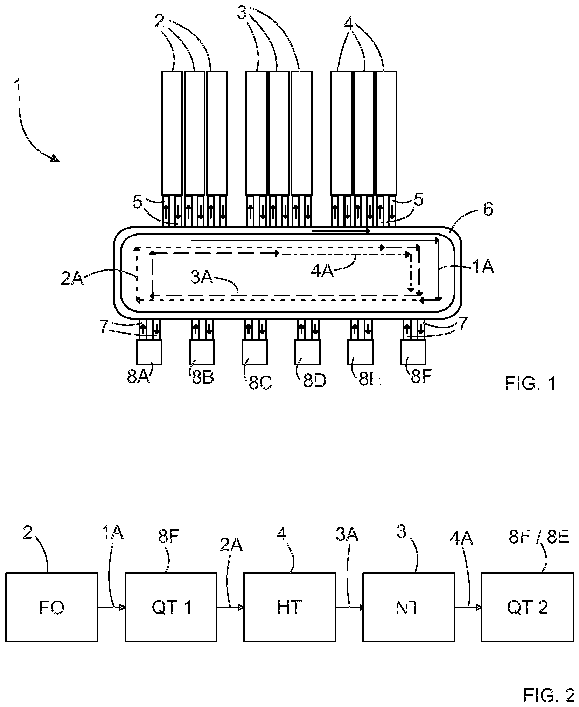

Figure 1 illustrates a known arrangement 1 for the formation and aging processes and the tests relating to the formation and the aging processes. The arrangement has rooms for the formation 2, normal temperature aging 3 (like room temperature), and high temperature aging 4 (like 30 - 50 Celsius). Li-ion cells are transported in and out the rooms by the conveyors 5. The Li-ion cells are handled in the formation rooms (and in the normal temperature rooms and the high temperature rooms) utilizing common and known solutions, which are not illustrated in the figures. So, the processes in the rooms and internal transport lines are known as such so, they are not described in this context.

Conveyors 5 are used to transport the cells in and out of the rooms in order to the transport them on a continuous conveyor 6. At another side of the continuous conveyor there are test devices 8A......8F which are functionally connected to the continuous conveyor by other conveyors 7 in order to transport the cells in and out of the test devices. The conveyors 5, 6, 7 are controlled in such a way that they transport the cells from a process to the next process as determined by manufacturing instructions, called also as a process recipe. Figure 2 shows a simple example of the process recipe relating to the formation, aging and tests to be made for these processes. In figure 2 the cells are in the formation room 2 for charging from where they are transported 1A into a test device 8F for measuring, for example voltage, internal resistance etc. In this phase it is possible to take away cells, which seem to be defective. Good cells are transported 2A to the high temperature room 4 for aging. After that the cells are transported 3A to the normal temperature aging 3 room according to the process recipe. After the normal temperature aging the cells are transported 4A to a test device, for example 8F or 8E. This is a final test phase according to this example. The required tests are made, defective cells can be taken away, and the accepted cells can be delivered for the next manufacturing phase to be assembled in battery packs (not illustrated in figures 1 and 2).

The process recipes are cell specific, so transport routes are fixed. Further, transport time from a process to another process can be long in known solutions. The conveyor lines can also block operator accessibility for process machines in error cases and for maintenance purposes. Since the transport routes are made especially for a certain process recipe, changing the process recipe means that the transport routes must be changed, in most cases. The changes of the routes can cause unexpected severe capacity problems, and other problems.

### Short description

The object of the invention is to alleviate or even eliminate the problems said above. The object is achieved in a way described in the independent claims. Dependent claims illustrate different embodiments of the invention.

A manufacturing arrangement to rechargeable battery cell formation and aging processes according to the invention has at least one room 2 for the formation process, at least one room 3, 4 for the aging process, and testing devices 8A, 8B, 8C, 8D, 8E, 8F. The rooms 2, 3, 4 and devices being situated on a floor 9. The arrangement further comprises a mezzanine floor 10 above the floor. On the mezzanine floor the arrangement comprises at least one linear robot system 11 supported on the mezzanine floor. An area wherein the linear robot system is capable to pick the rechargeable battery cells is a gathering area 13. The linear robot system 11 is movable to a desired location on the gathering area in order to transport the rechargeable battery cells.

The arrangement further comprises conveyors 14 on the mezzanine floor 10. Each of said rooms 2, 3, 4 has interfaces 15 being in a functional connection to at least one of the conveyors 14 in order to transport the rechargeable battery cells out of the room and into the room. The conveyors 14 are also partly on the gathering area 13. The mezzanine floor 10 has openings 16 on the gathering area.

On the floor 9, the arrangement further comprises elevator conveyors 17 being in functional connection with the opening 16 in order to transfer the rechargeable battery cells from the mezzanine floor to the floor and from the floor to the mezzanine floor. The arrangement also comprises second conveyors 18 on the floor to transport rechargeable battery cells from the elevator conveyors 17 to the testing devices 8A, 8B, 8C, 8D, 8E, 8F, and from the testing devices to the elevator conveyors.

### List of figures

In the following, the invention is described in more detail by reference to the enclosed drawings, where
- Figure 1: illustrates an example of a known arrangement for formation and aging processes,
- Figure 2: illustrates an example of a process recipe used with the arrangement of figure 1,
- Figures 3 and 4: illustrates an example of an arrangement for formation and aging processes according to the invention,
- Figure 5: illustrates an example of a process recipe used with the arrangement of figures 3 and 4,
- Figure 6: illustrates a side view from the example of figures 3 and 4,
- Figure 7: illustrates another example of an arrangement for formation and aging processes according to the invention,
- Figures 8 and 9: illustrates other views from the example of figure 7,
- Figures 10 and 11: illustrates also other views from the example of figure 7,
- Figure 12: illustrates a cut-away side view from the example of figure 7,
- Figure 13: illustrates an example of another process recipe used with the arrangement of figures 3 and 4 and also with the arrangement of figure 7, and
- Figure 14: illustrates an example of an arrangement for formation and aging processes according to the invention,

### Description of the invention

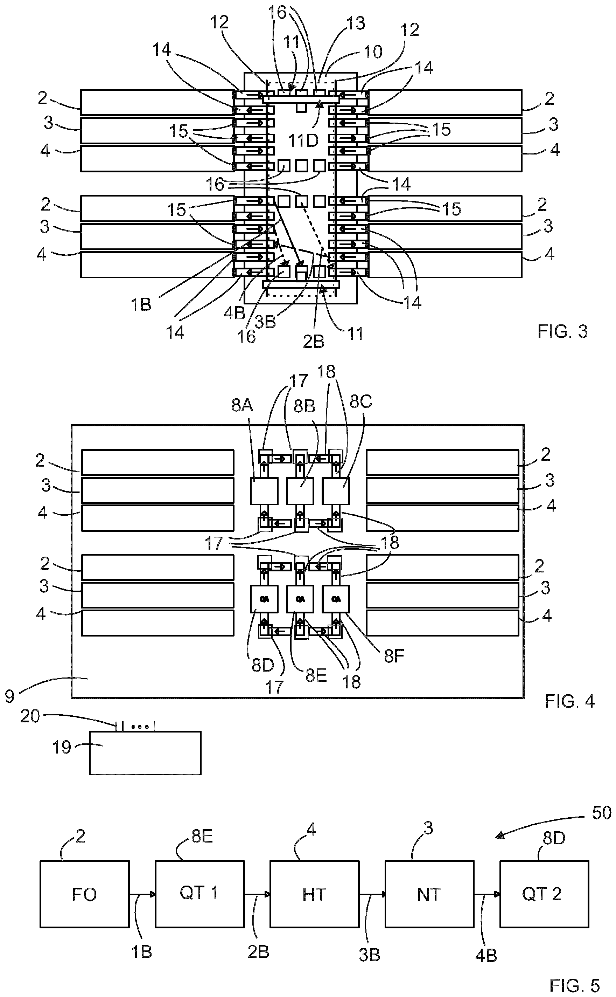

Figures 3 and 4 illustrates an example of a manufacturing arrangement to rechargeable battery cell formation and aging processes according to the invention. The arrangement has at least one room 2 for the formation process, at least one room 3, 4 for the aging process, and testing devices 8A, 8B, 8C, 8D, 8E, 8F. The rooms 2, 3, 4 and devices being situated on a floor 9. The arrangement further comprises a mezzanine floor 10 above the floor. On the mezzanine floor the arrangement comprises at least one linear robot system 11 supported on the mezzanine floor. An area wherein the linear robot system is capable to pick the rechargeable battery cells is a gathering area 13. The linear robot system 11 is movable to a desired location on the gathering area in order to transport the rechargeable battery cells.

The linear robot system can be a gantry robot system or a cartesian robot system. A gantry robot system may comprise two parallel beams. Between the beams, supported on the beams, there is a gantry robot unit being made up of a bridge beam 11 D and a gripper unit. The gantry robot unit/s can be moved along the beams. The gripper unit can be moved along the bridge beam. The gripper unit has a vertical beam / telescopic beam which is moveable in the vertical direction. An actual gripper, which can grip and release an object/s is attached to the vertical beam/telescopic beam. The example of figures 3 and 4 the linear robot is a gantry robot comprising two beams 12 supported on the mezzanine floor 10, and at least one gantry robot unit supported on the beams 12. The object/s to be picked and moved are the rechargeable battery cells.

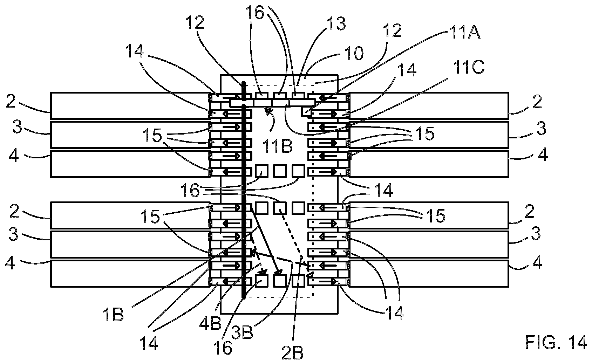

A gantry robot system may also have only one beam as the example of figure 14 illustrates. In this embodiment the gantry robot unit, which moves along the beam, has a horizontal beam, which is in the perpendicular direction in relation to the beam. The horizontal beam may be a telescopic beam. The gripper unit attached to the horizontal beam has a vertical beam / telescopic beam, which is moveable in the vertical direction.

As said, the linear robot system can also be a cartesian robot system, which means that it has a gripper or other operating part, which can be moved along x-y-z axes and or planes. In other words, it can be said that the gantry robots are also cartesian robots.

In the example of figures 3 and 4, the area between the beams is the gathering area 13. The gantry robot 11 is movable along the beams 12 to a desired location on the gathering area in order transport the rechargeable battery cells.

The arrangement further comprises conveyors 14 on the mezzanine floor 10. Each of said rooms 2, 3, 4 has interfaces 15 being in a functional connection to at least one of the conveyors 14 in order to transport the rechargeable battery cells out of the room and into the room. The conveyors 14 are also partly on the gathering area 13. The mezzanine floor 10 has openings 16 on the gathering area.

On the floor 9, the arrangement further comprises elevator conveyors 17 being in functional connection with the opening 16 in order to transfer the rechargeable battery cells from the mezzanine floor to the floor and from the floor to the mezzanine floor. The arrangement also comprises second conveyors 18 on the floor to transport rechargeable battery cells from the elevator conveyors 17 to the testing devices 8A, 8B, 8C, 8D, 8E, 8F, and from the testing devices to the elevator conveyors. In this context the functional connection means that the parts/devices are working together in order to do something, like transporting the cells. The parts/devices do not need to be in physical connection with each other, but they may also be physically separated, for example being near each other.

The arrangement comprises also a control system 19, which comprises at least one process recipe 50, 51 for the formation and aging processes and tests made by the testing devices. The control system has connections 20 for controlling the processes in the rooms 2, 3, 4, and the conveyor, the linear robot system/s (like gantry robot/s), the elevator conveyors, the second conveyors and the test devices. So, the control system 19 is arranged to control movements of said conveyors 14, linear robot system/s 11, elevator conveyors 17 and the second conveyors 18 in order to transport the cells according to the process recipe. It is noted that in this description the expression "cells" means rechargeable battery cells. The cells as described can be under manufacturing, so the cells does not mean only finished cells in this context.

In practice the control system may comprise several units like a main controller and sub-controllers. The control and monitoring measures can be divided among several units. For example, a so-called warehouse control system may control material handling devices, i.e. in this case the transportation of the cells by using the conveyors 14, the linear robot system/s 11, the elevator conveyors 17 and the second conveyors 18. The warehouse control system may have interface to a so-called manufacturing execution system, which maintains the process recipe/s and can trace the production processes even on the cell level.

Figure 5 shows an example of a process recipe 50 used with the arrangement of figures 3 and 4. This recipe is similar to the recipe illustrated in figure 2. Conveyors 14 are used to transport the cells in and out of the rooms 2, 3, 4. The conveyors extend into the gathering area 13. In the gathering area, the linear robot system/s 11 is used to transport the cells to a desired location, for example from one of the conveyers to the elevator conveyor 17 in some of the openings 16, and vice versa.

The test devices 8A...... 8F are situated on the floor 9 below the mezzanine floor 10. The test devices are functionally connected with the second conveyors 18 in order to transport the cells in and out of the test devices. The second conveyors are also functionally connected to the elevator conveyors 17 to transport the cells in and out of the elevator conveyors. The elevator conveyors are arranged to transport the cells between the mezzanine floor and the floor.

The conveyors 14, the linear robot system/s (here the gantry robot/s) 11, the elevator conveyors 17, and second conveyors 18 are controlled in such a way that they transport the cells from a process to the next process as determined by manufacturing instructions, i.e. a process recipe.

In the example of figure 5 (also figures 3 and 4) the cells are in the formation room 2 for charging from where they are transported 1B into a test device 8E for measuring, for example voltage, internal resistance etc. As can be seen in figure 3, the conveyor 14 transports the cells to the gathering area 13, wherein the linear robot system/s (the gantry robot) 11 picks the cells from the conveyor and transports the cells to one of the openings 16, which can be preferably near the test device 8E. The linear robot system/s puts down the cells for the conveyor elevator 17 in the openings, and the conveyor elevator transports the cell down to the floor 9 wherein in the cells are transferred to the second conveyor 18, which transports the cells to the test device 8E.

In this phase of the test device, it is possible to take away cells, which seem to be defective. It is also noted that if the process recipe comprises several test phases, the defective cells can be taken away from the manufacturing process in each test phase.

Good cells are transported 2B to the high temperature room 4 for aging. The good cells are transported by the conveyor 18 to the elevator conveyor 17, which can be the other or even the same conveyor, which transported the cell into the test device 8. It depends on the layout arrangement of the second conveyors, and the test devices on the floor 9. In figure 3 the separate second conveyors 17 are used to transport the cells from the elevator conveyors to the test devices and the other separate conveyors are used to transport the cells from the test devices to the other elevator conveyors. However as said, the layout of tests devices and the second conveyors can be different, so the second conveyors and the transportation routes on the floor 9 can be arranged as desired. A number of the test devices and the second conveyors can also be different than in the example of figures 3 and 4. The number of the openings 16 and their locations on the mezzanine floor 10 can also vary and be different than in the example of figures 3 and 4.

So, the elevator conveyor 17 transports the cells to the mezzanine floor 10 in the transportation phase 2B where the cells are transferred to the linear robot system/s 11, which transports the cells the conveyor 14, which in turn transports the cells into the high temperature room 4.

After the high temperature aging, the cells are transported 3B to the normal temperature aging room 3 according to the process recipe. So, the conveyor with the high temperature room in question transports the cells to the gathering area 13, where the linear robot system/s 11 picks them and transports them to the other conveyor being in the functionally connection with the normal temperature aging room 3. The other conveyor transports the cells into the normal temperature aging room.

After the normal temperature aging the cells are transported 4B to a test device, for example 8D. So, the other conveyor being also in functionally connected with the normal temperature room transports the cells to the gathering area 13 where the linear robot system (here the gantry robot) 11 picks the cells and transports them to one of the openings 16 for the elevator conveyor 17. The cells are transferred from the linear robot system11 to the elevator conveyor 17, which transports them down to the floor 9 wherein the cells are transferred from the elevator conveyor 17 to the second conveyor 18, which transports the cell into the test device 8D. This is a final test phase according to this example. The required tests are made, defective cells can be taken away, and the accepted cells can be delivered for the next manufacturing phase to be assembled in battery packs (not illustrated in figures).

Figure 3 shows two conveyors 14 per the formation room 2, normal temperature aging room 3 and the high temperature aging room 4, but the number of the conveyors 14 per room can also be another, like 1 or 4. The number of the conveyors depends on an embodiment. At least one linear robot system11 can be used. In the example of figure 3, two gantry robots are used in order to have redundancy.

As can be noted, in the inventive arrangement is very flexible. Transport routes of the cells are flexible, since the linear robot system can be directed as desired for transporting the cell in and out of any of the formation, high temperature, or normal temperature rooms. The test devices 8A..8F and the second conveyors 18 can be situated relatively freely on the floor 9. Also, the openings 16 and the elevator conveyors 17 can be situated relatively freely. Another significant advantage is that the arrangement already made can be easily used with many different recipes without making any changes to the transportation devices or their locations. However, if the layout of the arrangement needs to be changed due to a possible recipe change or changes, it can be easily adapted due to easy/unlimited accesses to the processes / devices. In addition, the transport time from a process to the next process can as arranged to be as short as possible.

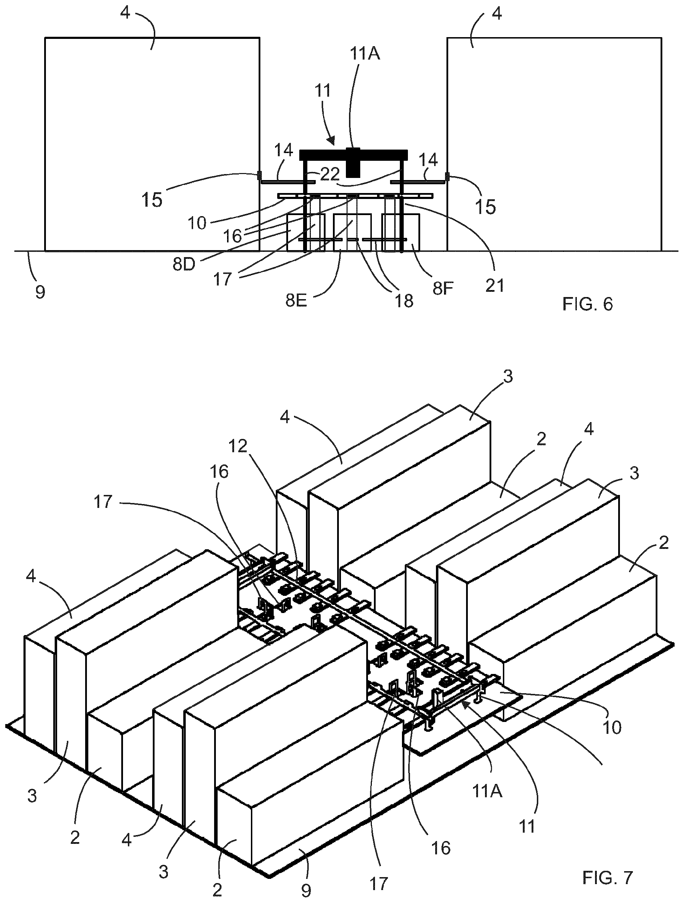

Figure 6 shows a side view from the example of figures 3 and 4. It shows the interfaces 15 being in a functional connection to at least one (in this example two) of the conveyors 14 in order to transport the rechargeable battery cells out of the room and into the room, the conveyors 14 being also partly on the gathering area 13. The gantry robot comprises a gripper unit 11A which picks up the cells. The cells are in a holder, like a tray or box, the gripper of the gripper unit grips the holder, lifts it up, and transport it to another location in the gathering area.

As mentioned, the formation, hight temperature and normal temperature rooms 2, 3, 4 are on the floor 9. They are high rooms, so the interfaces are situated up above the mezzanine floor 10 for the conveyors 14. Figure 6 shows also columns 22 that support the gantry robot 11. The mezzanine floor 10 is supported to a desired hight by other columns/structures 21. The mezzanine floor 10 has openings 16 on the gathering area for the elevator conveyors 17.

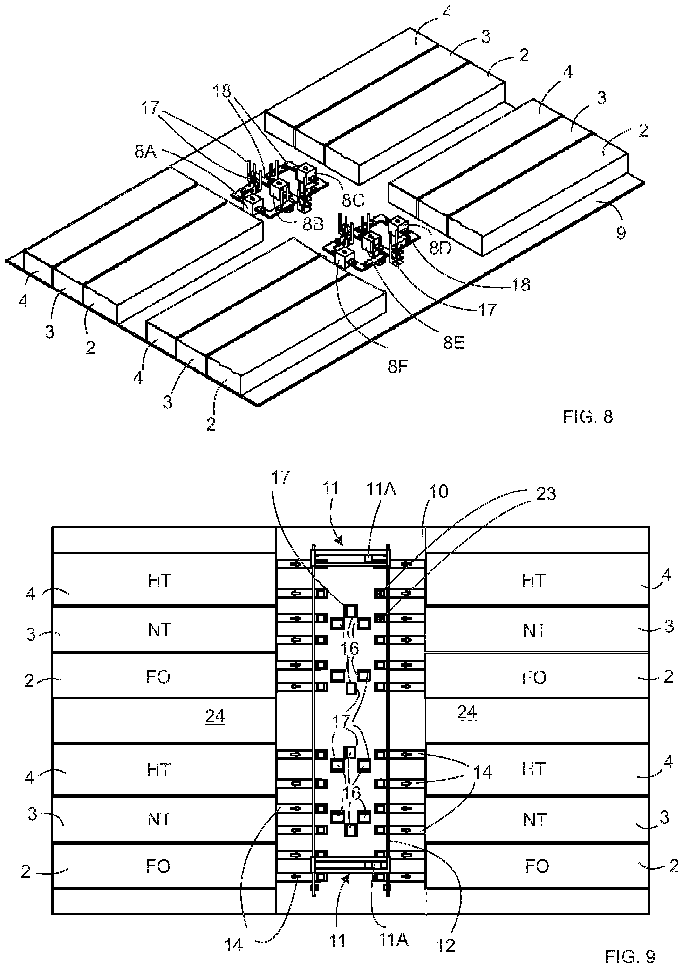

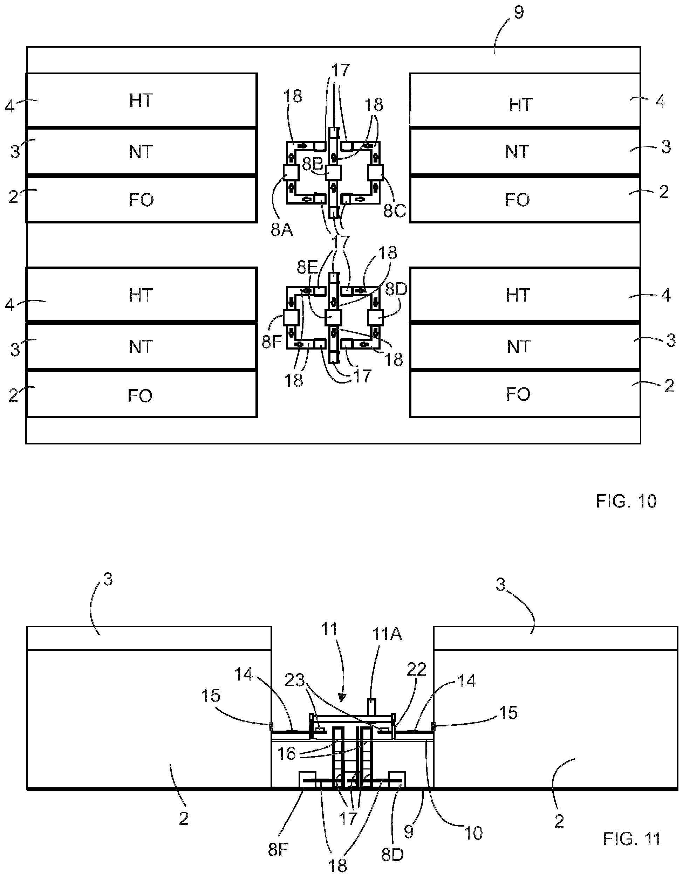

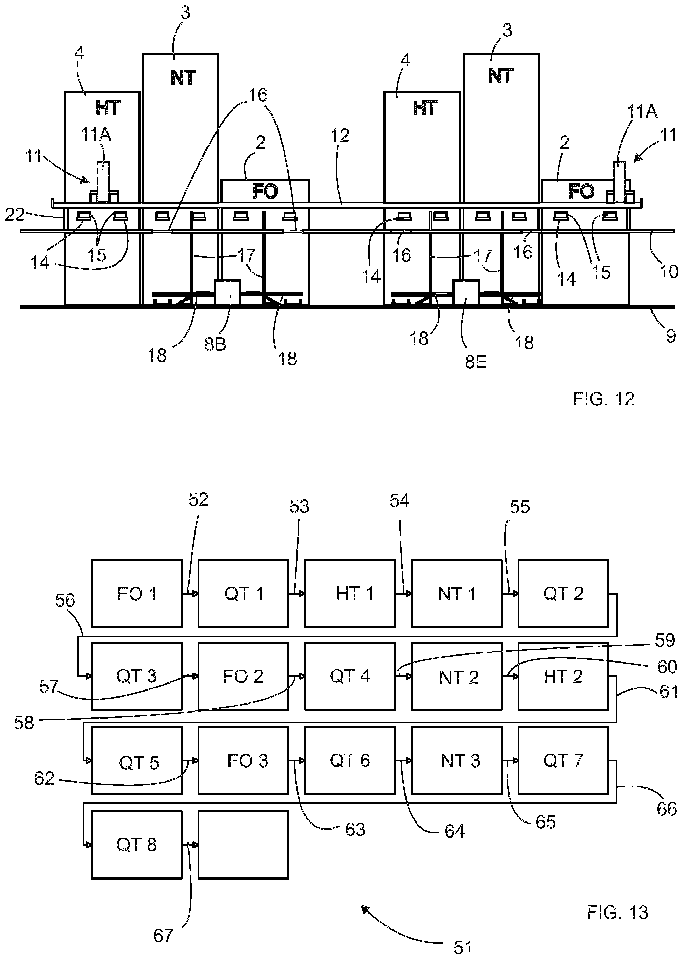

Figure 7 illustrates another example of an arrangement for formation and aging processes according to the invention. Figures 8, 9, 10, 11 and 12 illustrate other views from the example of figure 7, figure 8 a cut-away drawing showing the floor 9 and devices on it, and figure 9 a top view from the mezzanine floor 10. Figure 10 shows a top view from the floor 9, and figure 11 shows a side view. Figure 12 shows a cut-away side view. In this example the openings 16 have been made in different locations in on the mezzanine floor. So, the elevator conveyors 17 are also situated in a different way than in the example of figures 3 and 4. On the floor 9 the test devices 8A...8F and the second conveyors 18 are also situated slightly differently than in figure 4.

As can be noted, the hights of rooms 2, 3, 4 can be different. Also, the size and the shape of the mezzanine floor 10 can vary. For example, if designed so, the mezzanine floor 10 may contain passages 24 in order to have more maintenance routes / emergency exits. The cells are convenient to transport in the holders 23, like trays or boxes. It can be also seen that the rooms 2, 3, 4 can be positioned in a desired way.

Figure 13 illustrates an example of another process recipe 51, which can be used with the arrangement of figures 3 and 4 and also with the arrangement of figure 7. It is clearly more complex than the recipe of figure 5. The process recipes are cell type specific, and they can vary a lot. In figures the expression FO means the formation in some of the formation rooms 2. The expression QT means processes, like measurements, in some of the test devices 8A....8F. The expression HT means high temperature aging processes in some of the high temperature rooms 4. The expression NT means normal temperature aging processes in some of the normal temperature rooms 3. Since there are several steps for the formation and the aging processes, each process step is also numbered consecutively. As can be seen the aging process may comprise at least one room to a normal temperature aging, and at least one room to a high temperature aging.

First there is a formation process FO 1 whereto the cells are delivered from the previous manufacturing processes like the electrolyte filling process (not illustrated in the figures). After the FO 1 the cells are transported 52 to a test process QT 1 in some of the test devices. The transportation utilizes the conveyors 14, linear robot system ( like the gantry robot) 11, the elevator conveyors 17 and the second conveyors 18 in a similar way as already described above. After the QT 1 the cells are transported 53 back to the mezzanine floor 10 to the high temperature aging HT 1 in some of the high temperature rooms 4. The transportation 53 utilizes again the transportation devices, but now in a different order, the second conveyors 18, the elevator conveyors 17, the linear robot system11, and the conveyors 14. After the HT 1 aging the cells are transported 54 by the transportation devices (the conveyors 17, the linear robot system/s11, the elevator conveyors 17, the second conveyors 18) to a normal temperature aging process NT 1 according to the process recipe.

Next after, the NT 1 the cells are transported 55 by the transportation devices to the next testing process QT 2 after which process the cells are transported 56 to the next testing process QT 3 according to process recipe. So, the QT 2 may comprise certain measurement/s like voltage measurements, and the QT 3 may comprise other measurements like internal resistance measurements. Therefore, according to the inventive arrangement, it is easy to transport the cells from one of the test devices to the next test device. After the QT 3 the cells are transported 57 form the floor 9 up to the mezzanine floor to the next formation process FO 2. After the FO 2 the cells are transported 58 to the following test process QT 4 on the floor 9 level.

After the QT 4 the cells are transported 59 to the next aging process, in this process recipe to the normal temperature aging process NT 2, after which the cells are transported 60 to the high temperature aging process HT 2. After the HT 2 the cells are transported 61 to the following testing process QT 5 and after that the cells are transported 62 to the next formation process FO 3. After the FO 3 the cells are transported 63 to the testing QT 6, after which the cells are transported 64 to the normal temperature aging NT 3. After the NT 3 the cells are transported 65 to the testing QT 7. After the QT 7 the cells are transported 66 to a final test process QT 8. After the QT 8 the cells, which are accepted, are ready to be transported 67 to the next manufacturing phase to be assembled in battery packs (not illustrated in figures).

Figure 14 shows another example of an arrangement for formation and aging processes according to the invention. In this example, the linear robot system is a gantry robot 11B having one beam 12. the gantry robot unit, which moves along the beam 12, has a horizontal beam 11C , which is in the perpendicular direction in relation to the beam. The horizontal beam may be a telescopic beam. The gripper unit 11A attached to the horizontal beam has a vertical beam / telescopic beam, which is moveable in the vertical direction. In this example one gantry robot is used, but other embodiments are also possible. For example, two gantry robots having one beam can be used.

So, the transportations 52...67 can/may utilize the conveyors, the linear robot system/s, the elevator conveyors, and the second conveyors. The transportation routes are flexible, and they are controlled by the control system 19 according the process recipe in question. The inventive arrangement is so flexible that several process recipes can be run at the same time for different cell types. So, in most cases there is no need to change the layout of the arrangement i.e. the change places and devices, like the conveyors, the second conveyor or the test devices. However, if the changes are needed to be done, they can be made easily, because the arrangement allows easy accesses to the devices.

The invention can used to manufacture the rechargeable battery cells, for example, lithium-ion battery cells, sodium-ion battery cells, nickel manganese cobalt battery cells, nickel metal hydride battery cells, or lithium sulphur battery cells. The rechargeable battery cells can, for example, be used in laptops, computers, mobile phones, toothbrushes, tools and in vehicles (for example, so called electric vehicle batteries).

So, the invention has many benefits. The transport routes of the cells are flexible. The linear robot system/s has access from any process (formation, aging processes, and routes for the test device) output to any process input. The transportation system can be easily adapted to possible recipe changes due to unlimited access of process input/output locations.

The arrangement also enables adaptation for dynamic or exceptional changes of process recipe, for example based on a test device measurement results. The transport time from process to process can be as short as possible.

Since the battery cell holder transportation is mainly made on the mezzanine floor 10, it improves operator accessibility to floor level process devices / machines in error cases and for maintenance purposes.

In addition, the mezzanine area, i.e. the gathering area 13 can be used as a temporary buffer storage for cell or battery holders to prevent rush/jam situations for production flow. Several linear robot system/s, like gantry robot units on one gantry frame, give redundancy for material handling. Emergency exit routes for persons on the floor 9 are easier to realize, also on the mezzanine floor 10. Fire safety issues can also be taken better into account. For example, accessibility to individual cells is easy in case of fire. Further, in order to increase safety, the arrangement may comprise safety structures near the elevator conveyors, like cages, cage structures etc.

The figures describing the invention are schematical figures, not showing details of the arrangements. For example, all supports or support structures are not illustrated, like supports for the conveyors 14. In this way the figures illustrate more clearly the invention. There are many different ways to provide an arrangement according to the invention. For example, the elevator conveyors, the conveyors, the second conveyors, and the linear robot system/s can be in different constructions and solutions. Different product recipes can be used with one inventive arrangement. The testing devices can comprise devices to capacity measurements, pulse tests, internal resistance measurements, leakage tests, voltage tests etc. The invention provides a very flexible arrangement for the formation and aging processes and the tests relating to them.

It is evident from the above that the invention is not limited to the embodiments described in this text but can be implemented in many other different embodiments within the scope of the independent claims.

## Claims

1. A manufacturing arrangement to rechargeable battery cell formation and aging processes, the arrangement having at least one room (2) for the formation process, at least one room (3, 4) for the aging process, and testing devices (8A, 8B, 8C, 8D, 8E, 8F), said rooms (2, 3, 4) and devices being situated on a floor (9), **characterised in that** the arrangement further comprises a mezzanine floor (10) above the floor, on the mezzanine floor the arrangement comprises at least one linear robot system (11, 11B) supported on the mezzanine floor (10), an area wherein the linear robot system is capable to pick the rechargeable battery cells being a gathering area (13), the linear robot system (11) being movable to a desired location on the gathering area in order to transport the rechargeable battery cells, the arrangement further comprising conveyors (14) on the mezzanine floor (10),
each of said rooms (2, 3, 4) having interfaces (15) being in a functional connection with at least one of the conveyors (14) in order to transport the rechargeable battery cells out of the room and into the room, the conveyors (14) being also partly on the gathering area (13), the mezzanine floor (10) having openings (16) on the gathering area,
on the floor (9) the arrangement further comprises elevator conveyors (17) being in functional connection with the opening (16) in order to transfer the rechargeable battery cells from the mezzanine floor to the floor and from the floor to the mezzanine floor, the arrangement also comprising second conveyors (18) on the floor (9) to transport the rechargeable battery cells from the elevator conveyors (17) to the testing devices (8A, 8B, 8C, 8D, 8E, 8F), and from the testing devices to the elevator conveyors.

2. An arrangement according to claim 1, **characterised in that** the arrangement comprises a control system (19), which comprises at least one process recipe (50, 51) for the formation and aging processes and tests made by the testing devices.

3. An arrangement according to claim 2, **characterised in that** the control system (19) is arranged to control movements of said conveyors (14), linear robot system/s (11), elevator conveyors (17) and the second conveyors (18) in order to transport the cells according to the process recipe.

4. An arrangement according to claim 3, **characterised in that** the gathering area (13) is arranged to provide a buffer storage to the cells.

5. An arrangement according to any of claims 1 - 4, **characterised in that** the arrangement comprises holders (23) to transport them with the cells by using the conveyors, the linear robot system/s, the elevator conveyors, and the second conveyors.

6. An arrangement according to any of claims 1 - 5, **characterised in that** the said rooms for the aging process comprises at least one room (3) to a normal temperature aging, and at least one room (4) to a high temperature aging.

7. An arrangement according to any of claims 1 - 6, **characterised in that** the arrangement comprises safety structures near the elevator conveyors.

8. An arrangement according to any of claims 1 - 7, **characterised in that** the testing devices comprises devices to capacity measurements, pulse tests, internal resistance measurements, leakage tests, voltage tests.

9. An arrangement according to any of claims 1 - 8, **characterised in that** the rechargeable battery cells are lithium-ion battery cells, sodium-ion battery cells, nickel manganese cobalt battery cells, nickel metal hydride battery cells, or lithium sulphur battery cells.

10. An arrangement according to any of claims 1 - 9, **characterised in that** the linear robot system is a gantry robot (11) comprising two beams (12) supported on the mezzanine floor (10), the rest part of the gantry robot (11) supported on the beams (12), said gathering area (13) being between the beams.

11. An arrangement according to any of claims 1 - 9, **characterised in that** the linear robot system is a gantry robot (11B) comprising one beam (12) supported on the mezzanine floor (10), the rest part of the gantry robot (11B) supported on the beam (12).
